# EUROPEAN PATENT APPLICATION

(11) **EP 1 775 667 A2**
(43) Date of publication of application: **18.04.2007**
(21) Application number: 06255309.4
(22) Date of filing: 16.10.2006
(51) Int. Cl.: G06F 17/50, G06Q 30/00, G06Q 50/00

(54) **Automatic qualification of plant equipment**

(30) Priority: 17.10.2005 US 727572 P; 11.10.2006 US 548345
(71) Applicant: SIEMENS CORPORATE RESEARCH, INC., Princeton, New Jersey 08540 (US); SIEMENS AKTIENGESELLSCHAFT, 80333 München (DE)
(72) Inventor: Moritz, Soeren, 91353 Wimmelbach (DE); Kalenchits, Natasha, 90403 Nuremberg (DE)
(74) Representative: Vigars, Christopher Ian

(57) **Abstract**

A method for automatically linking resource data to graphical data includes: identifying a graphical data object in a set of data (410); selecting resource data for linking to the graphical data object (420); detecting repeated graphical data objects in the set of data (430); and linking the selected resource data to the detected repeated graphical data objects (440).

## Description

### BACKGROUND OF THE INVENTION

### 1. Technical Field

The present disclosure relates to the automation of mechanical equipment manufacture and plant construction and, more particularly, to digital manufacturing plant design.

### 2. Discussion of Related Art

Recent advances in technology have led to manufacturing and process automation systems that deliver greater performance, lower engineering costs in the development of automation solutions, and lower life cycle costs in the operation of plants. The potential for time and cost savings increases with systems and tools for optimizing the engineering workflow of a company, such as software tools that can provide product development, production planning and production design optimization before the commissioning of a plant.

A company's success or failure may depend on how quickly it can recognize and react to market shifts. New production plants must be planned, designed and constructed quickly. In this context, the idea of a "factory of the future" or "digital factory" has drawn attention. The basic concept of the digital factory involves generating a detailed virtual copy of the actual factory in the planning phase, in which product development and production planning are closely intertwined. Plant construction does not begin until the virtual products have passed through the digital factory and all optimization possibilities for product design and production have been implemented. Software tools that can provide a seamless transition from the digital factory model to the real factory may result in reduced plant commissioning times.

Automation engineering processes can be both customer- and sector-specific. For this reason, software solutions are needed that can be individually adapted to the processes. Recently, software tools such as the Simatic Automation Designer have set new standards in the automation of mechanical equipment manufacture and plant construction. The Automation Designer software can handle original computer-aided design (CAD) plans of the planned plant. Automation Designer uses the geometric planning data of the plant as its basis, which enables the automation environment to be planned, tested and optimized. The geometric planning data is imported into the software's digital engineering environment, which provides users with a transparent view of the layout-based plant structure while allowing them to navigate into the integrated software tools.

Prepared reusable templates for the equipment resources may be assigned to graphic representatives in a CAD layout. For example, automation characteristics may be assigned to plant equipment represented on the CAD layout. This process, which is referred to as "qualification" in the digital engineering environment of Automation Designer, involves two steps. First, it is necessary to manually identify the target equipment unit to be qualified, which requires finding the unit on the drawing. The second step is to establish a link to the target equipment by "dragging" a graphical representation of an automation object to a position on top of the original CAD layout and "dropping it" on the location of the equipment unit. The result is the assignment of the automation object characteristics to the graphical counterpart in the mechanical layout. The previously separate worlds of mechanical components and automation can be represented transparently in one plant structure. Based on these data, a user can generate the required projects for Step7, HMI, or CAE systems, etc.

The qualification process can require a great deal of effort when a CAD layout contains a large amount of details of the plant equipment. For example, the user has to drag all of the automation objects one at a time and drop each of them on the exact location of the graphical counterpart. In addition, a group of CAD elements can be links to a single automation object.

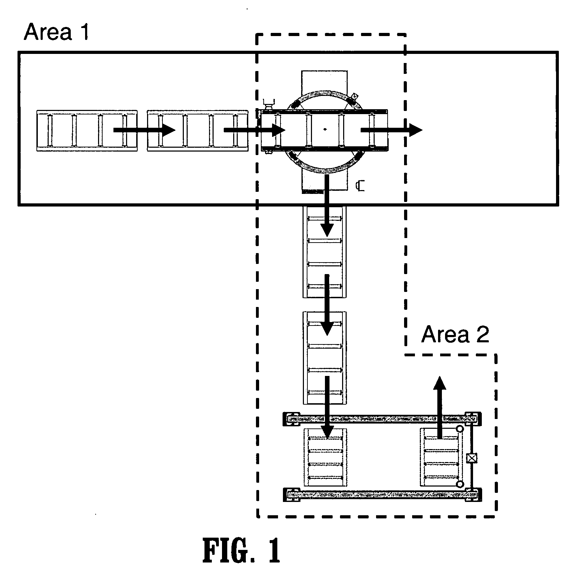

Plants are often subject to a high degree of standardization in mechanical and control technology and are typically planned with layout orientation. For example, plants may involve the use of skid conveyors or monorail overhead conveyors. FIG. 1 illustrates an example of a layout of plant equipment. In FIG 1, a system of conveyor units is shown.

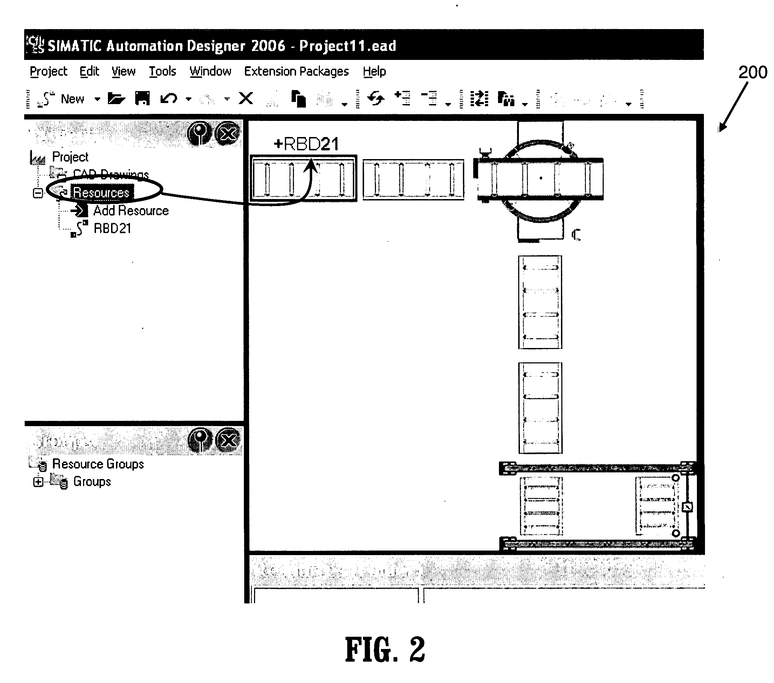

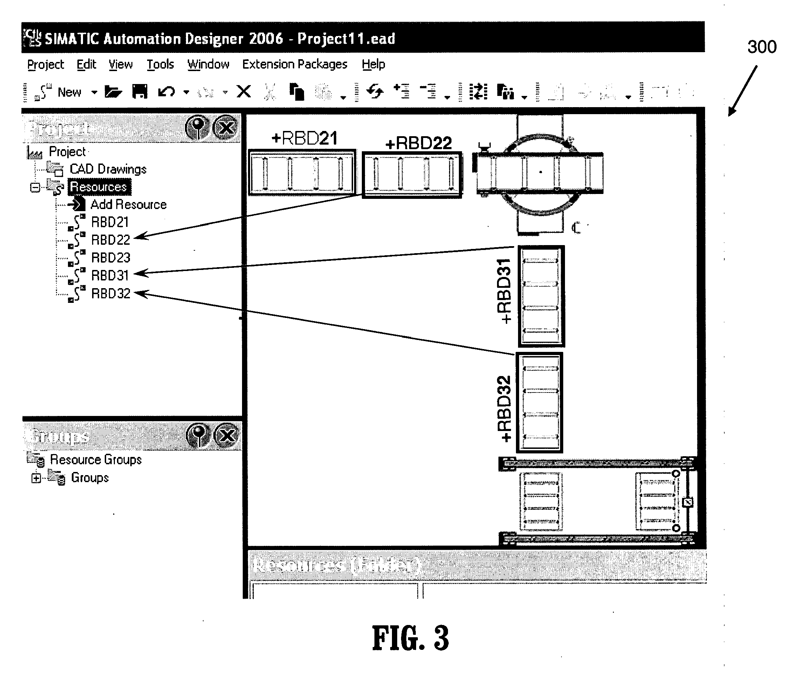

FIGS. 2 and 3 illustrate an example of a manual qualification process for the conveyors shown in the layout of FIG. 1. In the example depicted in FIGS. 2 and 3, the user must perform qualification a total of four times. That is, using a manual qualification process, the user must perform qualification for each conveyor unit of the same type. Referring to the graphical user interface 200 of FIG. 2, the user selects a resource and may click and drag (or cut/copy and paste) an icon representing the selected resource, using a pointing device, such as a mouse, that the user positions onto a graphical element RBD21 representing a conveyor unit in the CAD layout. Referring to the graphical user interface 300 of FIG. 3, the user performs the same steps for each of the conveyors units RBD21, RBD21 and RBD21 of the same type.

This results in qualification processes characterized by a high level of repetition of manual tasks that reduce efficiency and increase cost. In addition, manual plant equipment qualification processes can result in cost-intensive change management.

### SUMMARY OF THE INVENTION

According to an exemplary embodiment of the present invention, a method is provided for automatically linking resource data to graphical data. The method includes: identifying a graphical data object in a set of data; selecting resource data for linking to the graphical data object; detecting repeated graphical data objects in the set of data; and linking the selected resource data to the detected repeated graphical data objects.

According to an exemplary embodiment of the present invention, a system for providing automatic linking of resource data to graphical data comprises: a memory device for storing a program; a processor in communication with the memory device, the processor operative with the program to: identify a graphical data object in a set of data; select resource data for linking to the graphical data object; detect repeated graphical data objects in the set of data; and link the selected resource data to the detected repeated graphical data objects.

According to an exemplary embodiment of the present invention, a method is provided for automatically linking automation data to graphical data in a digital engineering environment. The method includes: identifying a graphical element in a layout in a digital engineering environment; selecting an automation component for linking to the graphical element; detecting repeated graphical elements in the layout; and linking the selected automation component to the detected repeated graphical elements in the layout.

### BRIEF DESCRIPTION OF THE DRAWINGS

The present invention will become more apparent to those of ordinary skill in the art when descriptions of exemplary embodiments thereof are read with reference to the accompanying drawings.
FIG. 1 illustrates an example of a layout of plant equipment.
FIGS. 2 and 3 illustrate an example of a manual qualification process for the plant equipment layout shown in FIG. 1.
FIG. 4 is a flowchart showing a method of automatically linking resource data to graphical data, according to an exemplary embodiment of the present invention.
FIG. 5 illustrates a computer system for implementing a method of automatically linking resource data to graphical data, according to an exemplary embodiment of the present invention.
FIG. 6 is a flowchart showing a method of automatically linking automation data to graphical data in a digital engineering environment, according to an exemplary embodiment of the present invention.

### DESCRIPTION OF EXEMPLARY EMBODIMENTS

Hereinafter, exemplary embodiments of the present invention will be described in detail with reference to the accompanying drawings.

The term "equipment" as used herein refers to a physical unit of a manufacturing process. Examples of equipment include lifting tables, conveyors, robots, machines, etc. "CAD" refers to computer-aided design. For example, a mechanical engineer may use CAD as a means to create a layout-based plant specification. "Automation object" as used herein refers to a unit of a plant responsible for sending, receiving and processing electrical signals to control production process. Examples include: software or hardware modules, programmable logic controller (PLC), I/O signals, push button, etc. The term "qualification" as used herein refers to a process of linking the layout representation of plant equipment with the related automation object. The term "resource" as used herein refers to a part of the plant which can be ordered, such as for example, equipment.

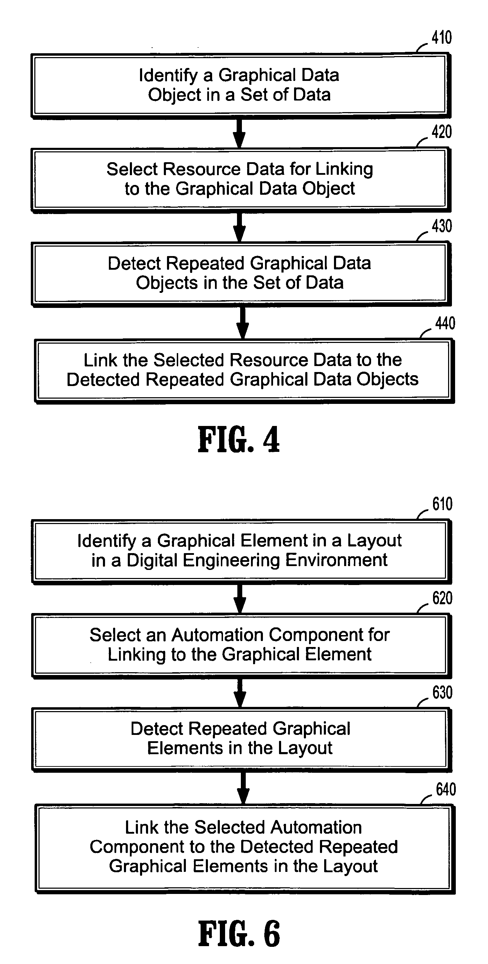

FIG. 4 is a flowchart showing a method of automatically linking resource data to graphical data, according to an exemplary embodiment of the present invention. Referring to FIG. 4, in step 410, identify a graphical data object in a set of data. The set of data may comprise a mechanical layout, geometric planning data, or a drawing, such as for example, a CAD drawing.

Identifying the graphical data object in the set of data may comprise receiving user input indicative of a selected graphical data object. It is to be understood that user interaction may not be required for identifying the graphical data object. In an exemplary embodiment of the present invention, identifying the graphical data object comprises automatically identifying the graphical data object. For example, the graphical data object can be automatically identified based on a comparison of the graphical data object with a library element in a CAD layout.

In step 420, select resource data for linking to the graphical data object. Resource data may include plant equipment, automation components, etc. Selecting resource data for linking to the graphical data object may include receiving user input indicative of a selected resource data.

In step 430, detect repeated graphical data objects in the set of data. It is to be understood that "repeated" graphical data objects are graphical data objects that are identical or substantially similar to the selected graphical data object. Detecting repeated graphical data objects in the set of data may include searching a CAD drawing database for repeated graphical data objects. Detecting repeated graphical data objects in the set of data may include using an image comparison technique, pattern recognition data analysis technique, etc. For example, pattern recognition for vector graphics can be used to detect the locations of the repeated graphical elements on a CAD drawing. A CAD drawing database may be searched for repeated graphical objects using conventional methods.

In step 440, link the selected resource data to the detected repeated graphical data objects. For example, linking the selected resource data to the detected repeated graphical data objects may include combining the selected resource data with a library element in a CAD layout. Linking the selected resource data to the detected repeated graphical data objects may include indicating a new field in a CAD database. In an exemplary embodiment of the present invention, linking the selected resource data to the detected repeated graphical data objects includes creating a layer to store resource information without changing mechanical information. The layer may be displayed on a graphical user interface (GUI), or not displayed, according to a user preference. Linked data objects may be displayed with a label, such as text label or icon, for example, to provide a visual cue to the user that the link has been established.

In an exemplary embodiment of the present invention, a method of automatically linking resource data to graphical data includes the step of importing a drawing or geometric planning data into a digital environment. A graphical user interface (GUI) may be provided. For example, the GUI may display a user-selectable display of resources.

It is to be understood that the present invention may be implemented in various forms of hardware, software, firmware, special purpose processors, or a combination thereof. In one embodiment, the present invention may be implemented in software as an application program tangibly embodied on a program storage device. The application program may be uploaded to, and executed by, a machine comprising any suitable architecture.

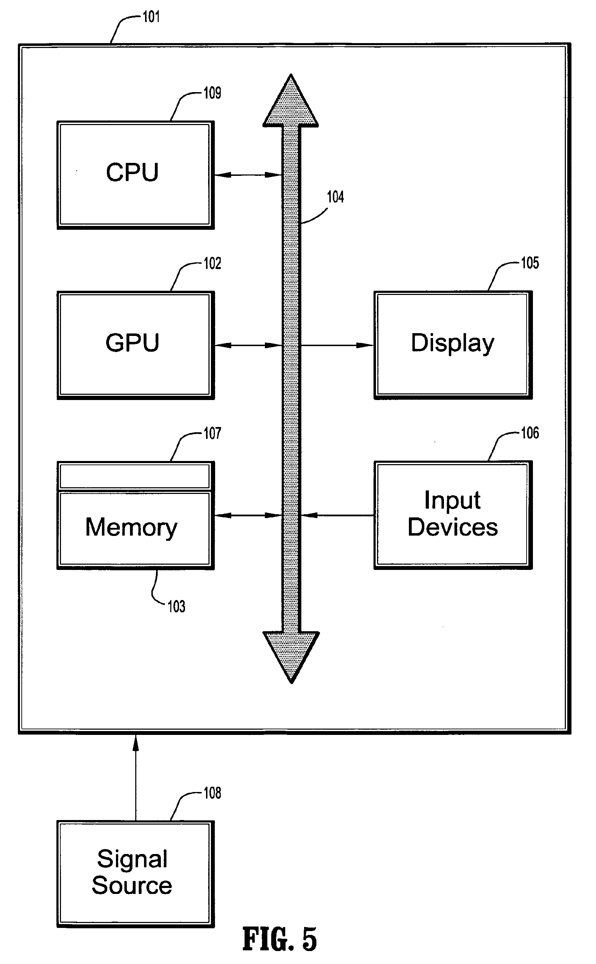

Referring to Figure 5, according to an embodiment of the present disclosure, a computer system 101 for implementing a method of automatically linking resource data to graphical data can comprise, inter alia, a central processing unit (CPU) 109, a memory 103 and an input/output (I/O) interface 104. The computer system 101 is generally coupled through the I/O interface 104 to a display 105 and various input devices 106 such as a mouse and keyboard. The support circuits can include circuits such as cache, power supplies, clock circuits, and a communications bus. The memory 103 can include random access memory (RAM), read only memory (ROM), disk drive, tape drive, etc., or a combination thereof. The present invention can be implemented as a routine 107 that is stored in memory 103 and executed by the CPU 109 to process the signal from the signal source 108. As such, the computer system 101 is a general purpose computer system that becomes a specific purpose computer system when executing the routine 107 of the present invention.

The computer platform 101 also includes an operating system and micro instruction code. The various processes and functions described herein may either be part of the micro instruction code or part of the application program (or a combination thereof) which is executed via the operating system. In addition, various other peripheral devices may be connected to the computer platform such as an additional data storage device and a printing device.

In an exemplary embodiment of the present invention, a system for automatically linking resource data to graphical data comprises a memory device 103 for storing a program, and a processor 109 in communication with the memory device 103. The processor 109 is operative with the program to: identify a graphical data object in a set of data; select resource data for linking to the graphical data object; detect repeated graphical data objects in the set of data; and link the selected resource data to the detected repeated graphical data objects.

The processor 109 may be further operative with the program to label the linked graphical data objects. The processor 109 may be further operative with the program to import a drawing or geometric planning data into a digital environment. The processor 109 may be further operative with the program to provide a graphical user interface for displaying a user-selectable display of resources.

It is to be further understood that, because some of the constituent system components and method steps depicted in the accompanying figures may be implemented in software, the actual connections between the system components (or the process steps) may differ depending upon the manner in which the present invention is programmed. Given the teachings of the present invention provided herein, one of ordinary skill in the related art will be able to contemplate these and similar implementations or configurations of the present invention.

FIG. 6 is a flowchart showing a method of automatically linking automation data to graphical data in a digital engineering environment, according to an exemplary embodiment of the present invention. For example, SIMATIC Automation Designer software may be employed to provide the digital engineering environment. It is to be understood that various software tools may be suitable for providing a digital engineering environment for use in connection with an exemplary embodiment of the present invention.

Referring to FIG. 6, in step 610, identify a graphical element in a layout in a digital engineering environment. For example, the layout may comprise a mechanical layout or a CAD drawing. Identifying the graphical element in the mechanical layout may include receiving user input indicative of a selected graphical element. In an exemplary embodiment of the present invention, user interaction is not required for identifying the graphical element.

In step 620, select an automation component for linking to the graphical element. For example, selecting an automation component for linking to the graphical element may comprise receiving user input indicative of a selected automation component.

In step 630, detect repeated graphical elements in the layout. Detecting repeated graphical elements in the layout may include searching a CAD drawing database for repeated graphical elements. Detecting repeated graphical elements in the layout may include using an image comparison technique, pattern recognition data analysis technique, etc. For example, pattern recognition for vector graphics can be used to detect the locations of the repeated graphical elements on a CAD drawing.

In step 640, link the selected automation component to the detected repeated graphical elements in the layout. Linking the selected automation component to the detected repeated graphical elements in the layout may include assigning characteristics of a plant hierarchical object to its counterpart in the layout. A plant hierarchy includes all parts of the plant arranged in hierarchical form. A plant hierarchical object may be an item and/or resource defined in ISA SP95.

ISA SP95 is a standard that defines the interface between control functions and other enterprise functions based upon the Purdue Reference Model for CIM (hierarchical form) as published by ISA. Items include enterprise, division, family, product/module and material/parts. Resources include enterprise, site, area, work center and equipment.

Although exemplary embodiments of the present invention have been described in detail with reference to the accompanying drawings for the purpose of illustration, it is to be understood that the inventive processes and apparatus are not to be construed as limited thereby. It will be readily apparent to those of reasonable skill in the art that various modifications to the foregoing exemplary embodiments can be made without departing from the scope of the invention as defined by the appended claims, with equivalents of the claims to be included therein.

## Claims

1. A method of automatically linking resource data to graphical data, comprising:
identifying a graphical data object in a set of data;
selecting resource data for linking to the graphical data object;
detecting repeated graphical data objects in the set of data; and
linking the selected resource data to the detected repeated graphical data objects.

2. The method of claim 1, wherein identifying the graphical data object comprises receiving user input indicative of a selected data object.

3. The method of claim 1, wherein identifying the graphical data object comprises automatically identifying the graphical data object.

4. The method of claim 3, wherein the graphical data object is identified based on a comparison with a library element in a CAD layout.

5. The method of claim 1, wherein resource data comprises a part of a plant which can be ordered.

6. The method of claim 5, wherein selecting resource data comprises receiving user input indicative of a selected resource data.

7. The method of claim 1, wherein detecting repeated graphical data objects in the set of data comprises searching a CAD drawing database for repeated objects.

8. The method of claim 1, wherein detecting repeated graphical data objects in the set of data comprises using an image comparison technique or a pattern recognition data analysis technique.

9. The method of claim 1, wherein linking the selected resource data to the detected repeated graphical data objects comprises combining the selected resource data with a library element in a CAD layout.

10. The method of claim 1, wherein linking the selected resource data to the detected repeated graphical data objects comprises indicating a new field in a data store.

11. The method of claim 1, wherein linking the selected resource data to the detected repeated graphical data objects comprises creating a layer to store linking information without changing mechanical information.

12. The method of claim 11, wherein the layer is displayed on a graphical user interface or not displayed according to a user preference.

13. The method of claim 1, further comprising labeling the linked graphical data objects.

14. The method of claim 1, further comprising importing a drawing or geometric planning data into a digital environment.

15. The method of claim 1, further comprising providing a graphical user interface for displaying a user-selectable display of resources.

16. A system for providing automatic linking of resource data to graphical data, comprising:
a memory device for storing a program;
a processor in communication with the memory device, the processor operative with the program to:
identify a graphical data object in a set of data;
select resource data for linking to the graphical data object;
detect repeated graphical data objects in the set of data; and
link the selected resource data to the detected repeated graphical data objects.

17. The system of claim 16, wherein the processor is further operative with the program code to label the linked graphical data objects.

18. The system of claim 16, wherein the processor is further operative with the program code to import a drawing or geometric planning data into a digital environment.

19. The system of claim 16, wherein the processor is further operative with the program code to provide a graphical user interface for displaying a user-selectable display of resources.

20. A method of automatically linking automation data to graphical data in a digital engineering environment, comprising:
identifying a graphical element in a layout in a digital engineering environment;
selecting an automation component for linking to the graphical element;
detecting repeated graphical elements in the layout; and
linking the selected automation component to the detected repeated graphical elements in the layout.

21. The method of claim 20, wherein identifying the graphical element comprises automatically identifying the graphical element.

22. The method of claim 20, wherein linking the selected automation component to the detected repeated graphical elements in the layout comprises assigning characteristics of a plant hierarchical object to its counterpart in the layout.

23. The method of claim 20, wherein the plant hierarchical object is an item or resource defined in ISA SP95.

24. The method of claim 20, wherein the layout is a mechanical layout.

25. The method of claim 20, wherein the digital engineering environment is provided by using SIMATIC Automation Designer software.
